# EUROPEAN PATENT SPECIFICATION

(11) **EP 1 342 305 B1**
(45) Date of publication and mention of the grant of the patent: **27.04.2005**
(21) Application number: 01270942.4
(22) Date of filing: 13.12.2001
(51) Int. Cl.: H02J 1/00, H02M 3/335

(54) **MODULARIZED POWER SUPPLY**
MODULARISIERTE STROMVERSORGUNG
BLOC D'ALIMENTATION MODULARISE

(30) Priority: 13.12.2000 US 737500
(43) Date of publication of application: 10.09.2003
(73) Proprietor: Delta Energy Systems (Switzerland) AG, 3018 Bern-Bümpliz (CH)
(72) Inventor: JITARU, Ionel, Dan, Tucson, AZ 85711 (US)
(74) Representative: Roshardt, Werner Alfred, Dipl.-Phys.
(86) International application number: PCT/CH2001/000712
(87) International publication number: WO 2002/049194

(56) References cited:
- EP-A- 0 860 926
- EP-A- 0 881 735
- DE-A- 19 704 662
- US-A- 5 936 318
- US-A- 5 969 965
- US-A- 6 141 231
- PATENT ABSTRACTS OF JAPAN vol. 1995, no. 11, 26 December 1995 (1995-12-26) & JP 07 222456 A (MEIDENSHA CORP), 18 August 1995 (1995-08-18)
- PATENT ABSTRACTS OF JAPAN vol. 1998, no. 02, 30 January 1998 (1998-01-30) & JP 09 275679 A (MITSUBISHI ELECTRIC CORP), 21 October 1997 (1997-10-21)

## Description

### Background of the Invention

The present invention relates to a modularized power supply.

Power supplies require power processing circuitry (hereinafter "power circuitry") and control and conditioning circuitry for controlling and conditioning the power processed by the power processing circuitry. The power circuitry typically includes a transformer, a rectifier, switching elements, and power sensing elements, and is alternatively referred to herein as a "power train." The control and conditioning circuitry typically includes an input filter, a bias supply, a control section and an output filter. The power train is typically mounted on a metal base that mechanically supports and heat sinks the power circuitry. The control and conditioning circuitry is typically mounted on a circuit board that is mounted above the power train.

In some power supplies, a number of power supply modules are ganged together to provide manufacturing flexibility. For example, a 1000 watt power supply may be constructed by coupling four 250 watt power modules together. Typically, each of the modules includes the aforementioned power train and control and conditioning circuitry. Therefore, the input filter, bias supply, control section and output filter are provided for each module in addition to the power train, increasing the cost of the power supply, its size and complexity, while at the same time decreasing its reliability. Moreover, because each module or power supply unit incorporates its own control and conditioning circuitry proximate its power circuitry, heat and noise generated by the power circuitry is passed on to the control circuitry.

Another problem arises in the art of power supplies generally because the manufacturing or fabrication technology used to construct the power train generally differs from that used to construct the control and conditioning circuitry. For example, much thicker copper traces are required in the power train than are desirable for the control section of the control circuitry. Accordingly, power supply systems, including power supply modules for use in a modular power supply, have typically required an additional manufacturing process to integrate the different circuits, resulting in higher cost.

in most applications of the modularized power supply, the outputs of the modules must be synchronized to properly share the output current. In those instances, additional control is required at the system level, further increasing the size, cost and complexity of the power supply. Moreover, there are limits to the amount of control that the system can have on the modules because of the operation of the module's own control circuits.

The present inventor is aware of a prior art "booster" DC-DC converter module in which the control section is omitted. The booster operates in parallel with another DC-DC converter module that controls itself and the booster. The system addresses, to some extent, some of the problems mentioned above. However, the system does not omit the input and output filters at the booster level, so that size and manufacturing cost of the system is not reduced to the extent possible, and the system does not provide for controlling the booster modules independently, which prevents the implementation of some strategies that optimize current sharing among the boosters.

Accordingly, there is a need for a modular power supply that provides for decreased complexity, manufacturing cost and size, and increased reliability, and that provides for increased control of the modules.

### Summary of the Invention

The modular power supply of the present invention solves the aforementioned problems and meets the aforementioned needs by providing a plurality of power supply modules and a system control circuit for controlling the power supply modules. Each power supply module has a power circuit coupled to a power input of the module for receiving an input power current and produces an output power current at a power output of the module. The power circuits each include at least one switching element for switching the input power current or the output power current of a module. The power circuits further include a control circuit input that is coupled directly to the respective said switching device. The system control circuit has a control circuit output bus for connecting to the control circuit inputs of each of the power modules and provides a respective control signal to each module for directly controlling the respective switching devices.

Preferably, the power circuits each include at least one sensing element for sensing a condition of the input power current or the respective said output power current of each module. For this purpose, the power circuits further include a control circuit output that is coupled directly to the respective sensing elements for providing a respective sense signal to said system control circuit. The system control circuit then further includes a control circuit input bus for connecting to the respective control circuit outputs of each of the power modules and directly receives the signals from the modules.

Therefore, it is a principal object of the present invention to provide a novel and improved modular power supply.

It is another object of the present invention to provide a modular power supply that provides for decreased manufacturing cost.

It is still another object of the present invention to provide a modular power supply that provides for decreased complexity.

It is yet another object of the present invention to provide a modular power supply that provides for decreased size.

It is a further object of the present invention to provide a modular power supply that provides for increased reliability.

It is still a further object of the present invention to provide a modular power supply that provides for increased control of the individual modules in the power supply.

The foregoing and other objects, features and advantages of the present invention will be more readily understood upon consideration of the following detailed description of the invention, taken in conjunction with the following drawings.

### Brief Description of the Drawings

Figures 1 - 16 are found in the inventor's prior application, Serial No. 09/310,627 as incorporated by reference herein.
Figure 17 is a schematic of a prior art module for a modularized power supply
Figure 18 is a schematic of a prior art power supply system employing a plurality of the modules of Figure 17.
Figure 19 is a schematic of module for a modularized power supply according to the present invention.
Figure 20 is a schematic of a power supply system according to the present invention employing a plurality of the modules of Figure 19.
Figure 21 is a top view of a first package for power electronic components employing airflow cooling for use with the present invention.
Figure 22 is a pictorial view of a second package for power electronic components employing airflow cooling for use with the present invention.
Figure 23 is a pictorial view of a third package for power electronic components employing airflow cooling for use with the present invention.
Figure 24 is a cross-section of a fourth package for power electronic components providing for enhanced thermal conductivity for use with the present invention.

### Detailed Description of a Preferred Embodiment

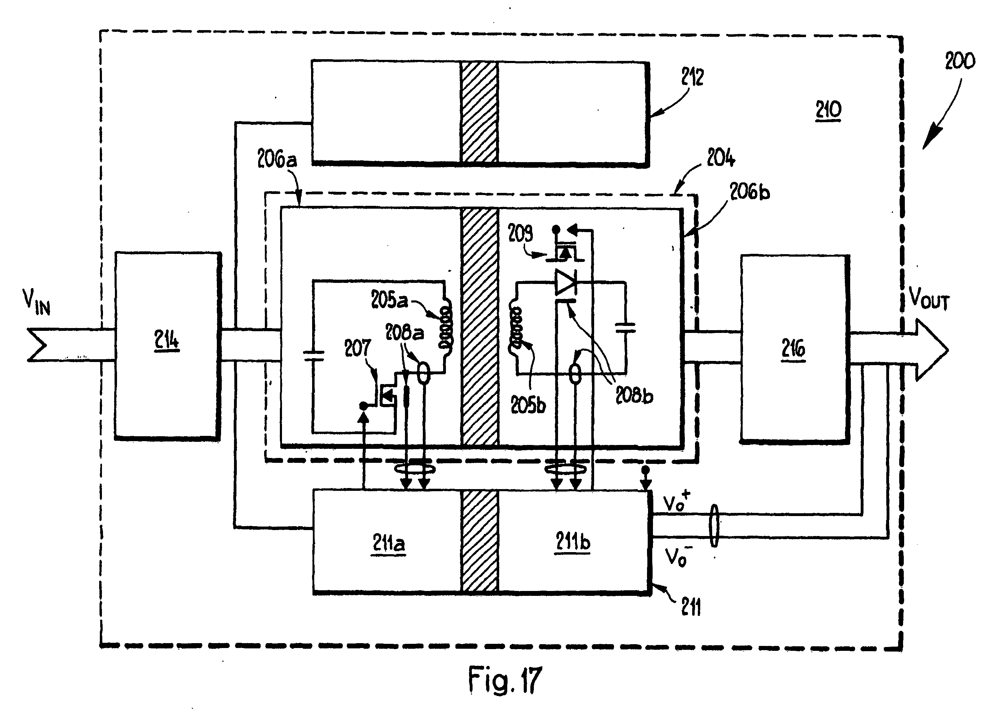

Figure 17 shows a prior art module 200 for use in a prior art modular power supply. A power train 204 includes a primary section 206a and a secondary section 206b. The primary section 206a includes the primary 205a of a power transformer 205, switching devices 207, such as power BJTs, FETs or IGBTs and sensors 208a for sensing the input current and the temperature of the switching devices. The secondary section 206b includes the secondary 205b of the power transformer, switching elements 209 such as FETs, diodes and synchronous rectifiers, and sensors 208b for sensing the output current and the temperature of the switching elements.

A control and conditioning circuit 210 is also provided to control the power train 204. The control and conditioning circuit 210 includes a control section 211 having a primary control portion 211a which receives data from the sensors 208a and controls the switching devices 207, and a secondary control portion 211b which receives data from the sensors 208b and controls the switching devices 209. To provide for operation of the module 200, the control and conditioning circuit 210 further includes a bias supply 212 for supplying the control section 211, and conditioning circuitry including an input filter 214 to smooth the input voltage Vin, and an output filter 216 to ensure that noise in the output voltage Vout does not exceed a predetermined level. As mentioned previously, the power train 204 is typically manufactured with one technology and mounted on one kind of substrate, such as a metal base plate, and the control and conditioning circuit 210 is typically manufactured with another technology and is mounted on a different kind of substrate, such as a printed circuit board.

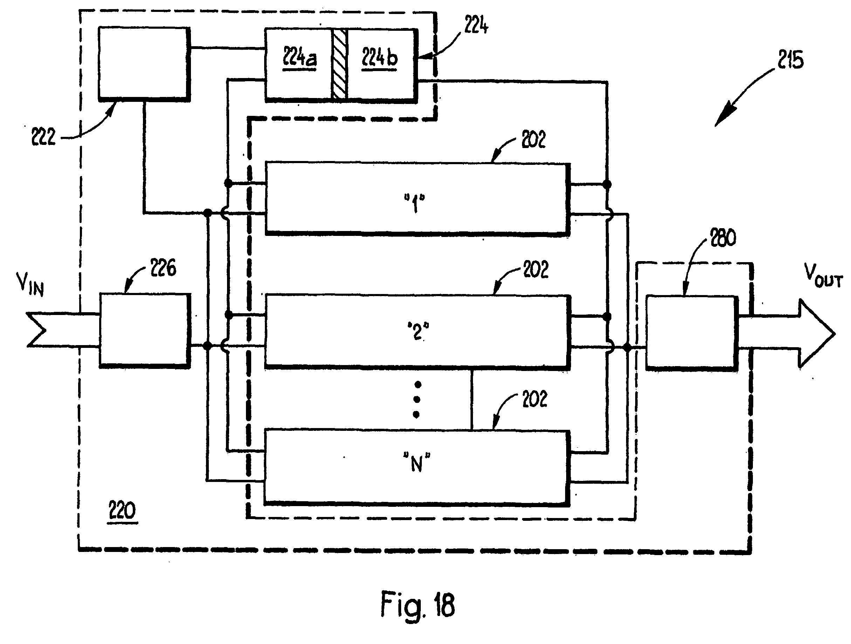

Turning to Figure 18, a prior art modular power supply 215 is shown employing a plurality of the modules 202 connected in parallel. The supply 215 includes a system control and conditioning circuit 220 including a system bias supply 222, a system control section 224, a system input filter 226 and a system output filter 228. Like the control section 211, the control section 224 includes a primary control section 224a and a secondary control section 224b. Similarly, the system bias supply 222 and the system input and output filters have an analogous function in the power supply 215 that the corresponding elements have in the module 202. However, as mentioned previously, the system control and conditioning circuit 220 may only control the modules 202 within limits, because the control and conditioning circuit 220 must act through the local control and conditioning circuits 210 of the modules.

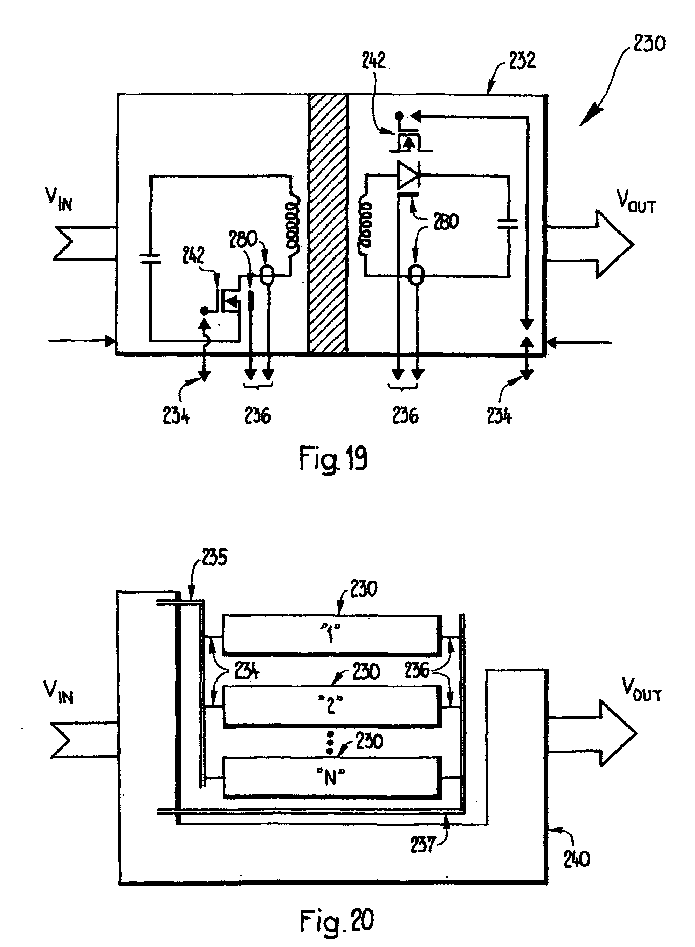

Turning to Figure 19, a power module 230 according to the present invention is shown. The power module 230 may be described as a "bare" power module because it includes a power train 232, control inputs 234 and sensor outputs 236 for communicating with an external system control and conditioning circuit, but does not have a control and conditioning circuit of its own. The modules 230 provide "direct" connections between at least the control inputs 234 and the underlying switching elements 242, meaning herein that the couplings are not moderated by an intervening control circuit for controlling the switching elements as in the prior art. For example, direct control may be obtained through intervening buffers and driver circuits, but not through circuits that would provide for independent control of the duty cycle of the switching elements. To operate the module 230, a system control and conditioning circuit 240 similar to the control and conditioning circuit 220 is provided for a plurality of the modules 230. Turning to Figure 20, the system control and conditioning circuit 240 has a control circuit output bus 235 for communicating with the respective control inputs 234 and thereby directly controlling the switching elements of each module. Preferably as well, the modules 230 provide direct connections between the sensor outputs 236 and underlying sensors 280 of the modules, and a control circuit input bus 237 is provided for communicating with the respective sensor outputs 236 to obtain a similar elimination of intermediate layers of control.

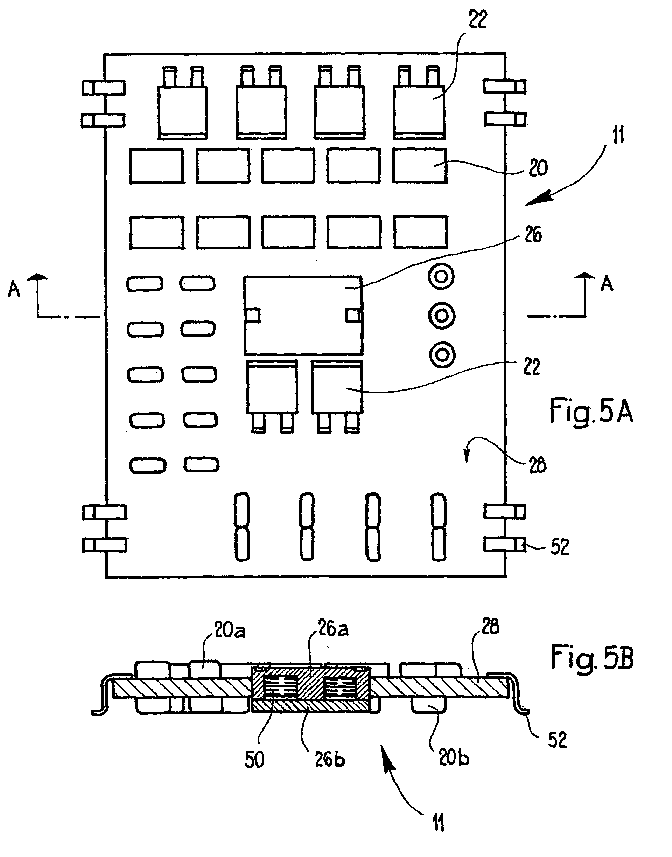

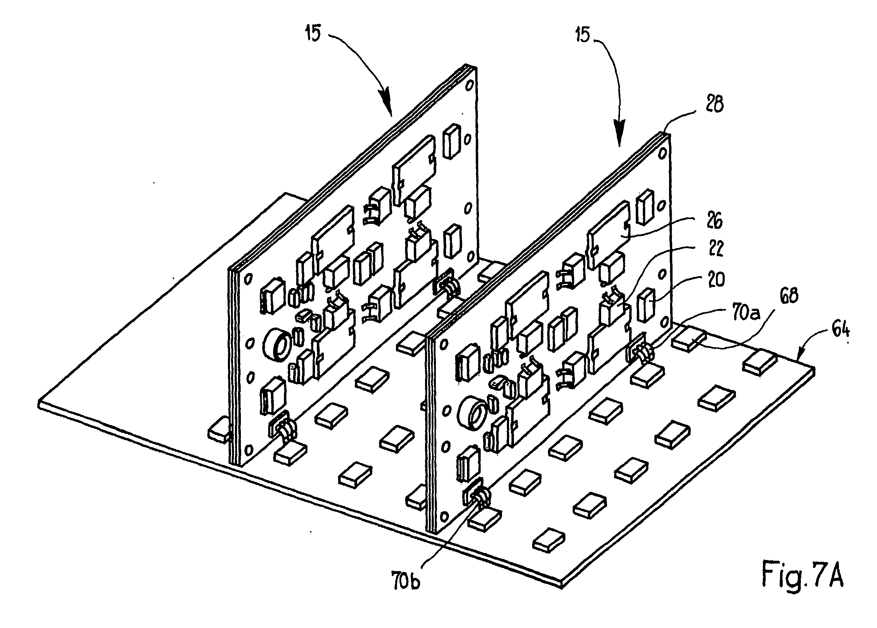

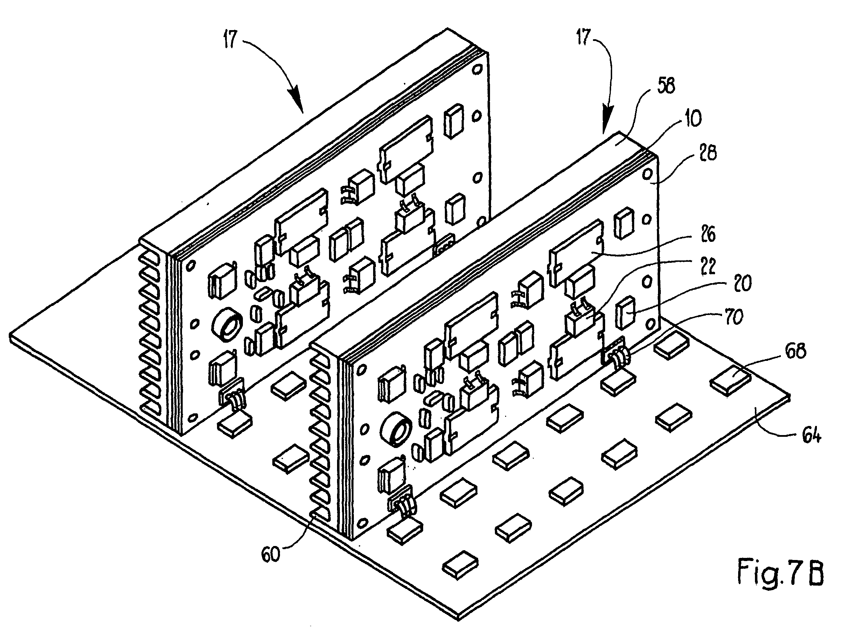

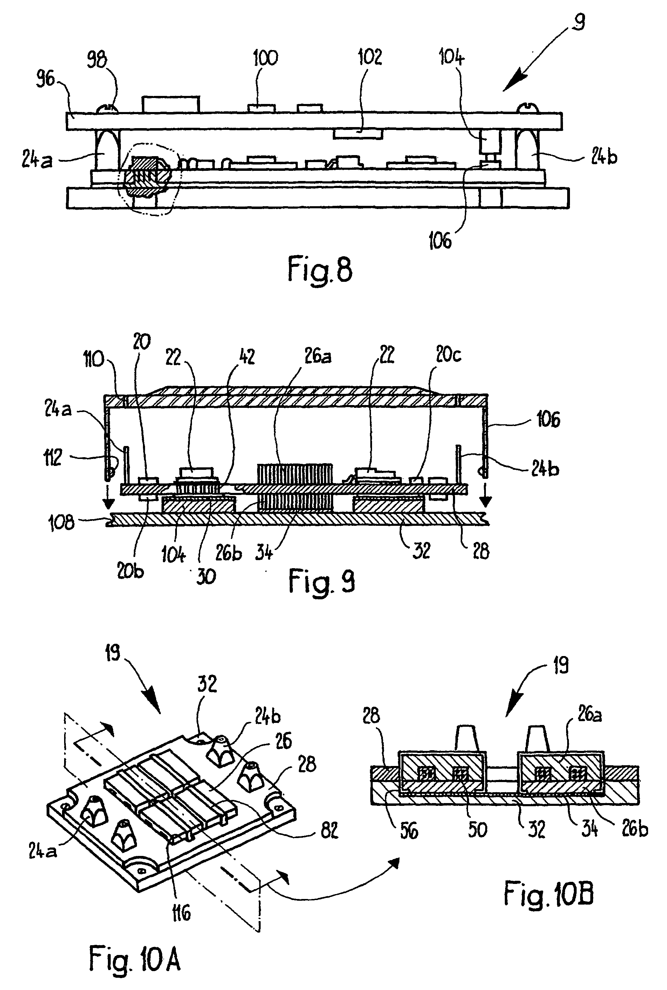

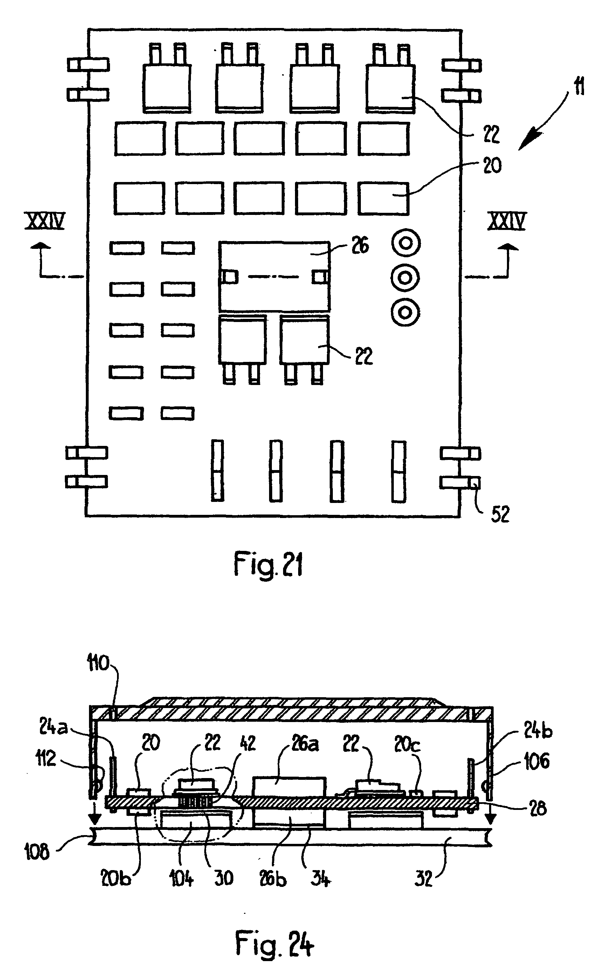

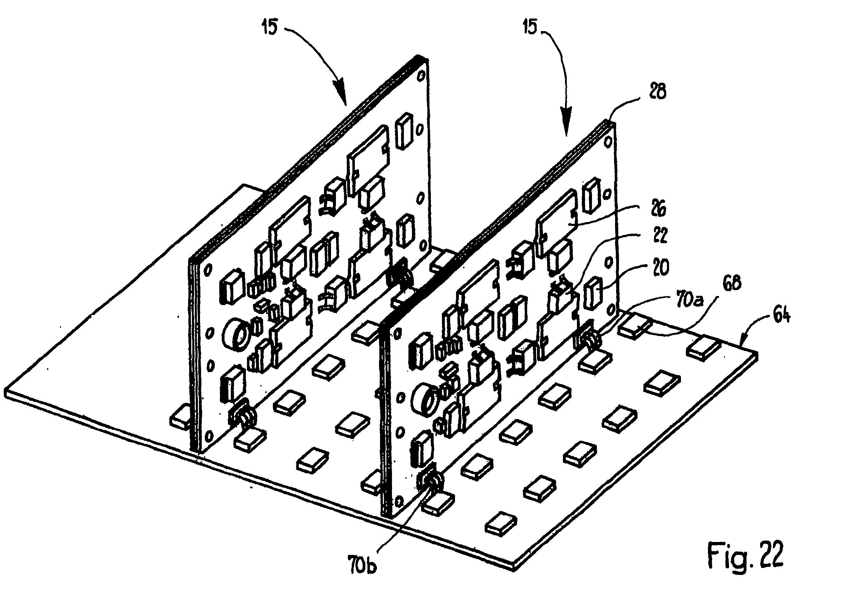

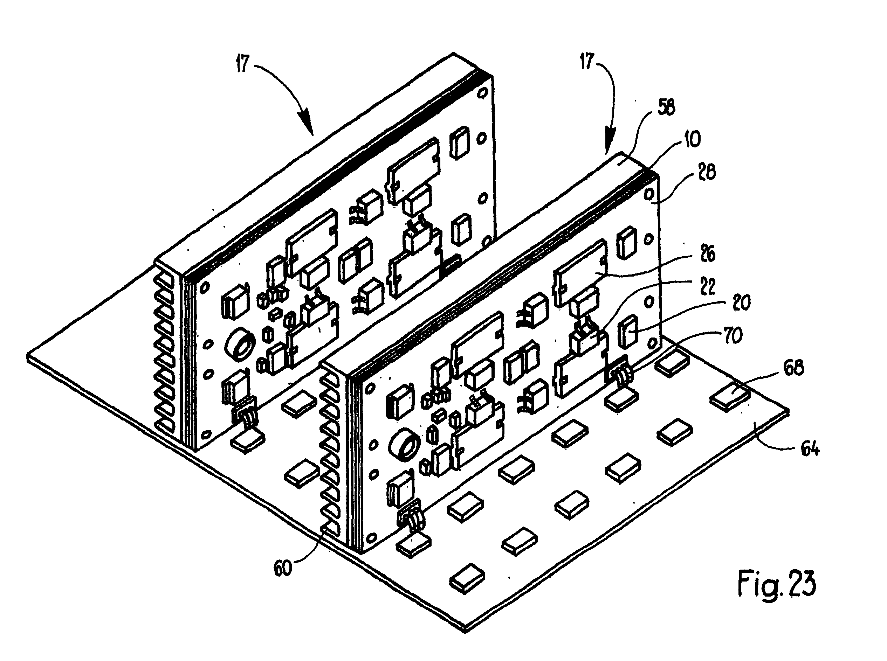

Each of the power modules 230 are preferably provided with enhanced thermal characteristics as described in application Serial No. 09/310,627. For example; referring to Figure 21, which reproduces Figure 5A of that application, airflow cooling may be used for the modules 30 in the manner of the PCB 28. Referring to Figure 22, which reproduces Figure 7A of application Serial No. 09/310,627, a motherboard 64 may be used for the system control circuit 240, while the modules 30 may be installed in the manner of the structures 15. Referring to Figure 23, which reproduces Figure 7B of application Serial No. 09/310,627, an additional heat sink may be attached to the modules 30 in the manner of the heat sink 58. Referring to Figure 24, which reproduces Figure 9 of application Serial No. 09/310,627, the modules 30 may be attached to a thermally conductive base in the manner of the PCB 28, thermally conductive insulator 30 and metal plate 32.

Direct system control of "bare" power modules according to the present invention provides for a number of advantages. Fundamentally, it provides that the modules may be controlled to a higher degree, without the limitations imposed by internal control circuits therein, and that the modules may be controlled independently of one another, providing for greatly increased flexibility. A few illustrations of this flexibility are given below, and others will be readily apparent to persons of ordinary skill in light thereof.

As an example of providing a higher degree of control for each module, the direction of power flow may be changed between the primary and secondary by the system control circuit without the limitations imposed by intermediate control circuits that have heretofore been required at the module level. The power transfer can be modulated as desired, and centrol of the voltage and current for the modules can be tailored as needed.

As an example of providing independent control of the modules, the modules may be interleaved or sequenced the system control circuit. This method can be used, for example, to increase the input and output ripple frequency of the system as a whole, which permits reducing the size and cost of the input and output filters. In the prior art, input and output filters are provided in the modules themselves, so that no reduction in size or cost of the filters as a result of operation of the modules is possible.

As yet another example, in operation at light load, the system control circuit may turn off selected power modules and process the power with a selected subset of the power modules, increasing the efficiency of light load operation of the system as a whole by eliminating the requirement to control all of the power modules. The amount of power processed by each module may be otherwise sequenced, balanced or distributed to suit environmental or other conditions of the modules, such as their temperature for optimizing cooling of the system as a whole.

All of this flexibility in control may be enhanced by employing programmable, digital control in the system control circuit, and such programmable control may further provide for easy customization of the power processing system, either in manufacturing or by the end-user.

The "bare" modules also have a significantly reduced complexity and therefore have lower cost and greater reliability. Space and cost are also reduced by eliminating redundancy. The system control circuit 220 is preferably located at a distance from the heat and noise producing modules, and this is made possible by eliminating the local control circuits provided in the prior art modules.

It is to be recognized that, while a particular modular power supply has been shown and described as preferred, other configurations and methods could be utilized, in addition to those already mentioned, without departing from the principles of the invention. The terms and expressions which have been employed in the foregoing specification are used therein as terms of description and not of limitation, and there is no intention of the use of such terms and expressions of excluding equivalents of the features shown and described or portions thereof, it being recognized that the scope of the invention is defined and limited only by the claims which follow.

Now following a part of the description of the inventor's prior US patent application Serial No. 09/310,627 to which herebefore was referred on page 1 and page 6.

This invention is related to the packaging of electronic components. It involves a new method of transferring heat from power components in a given electrical circuit to a heat sink underneath the PCB.

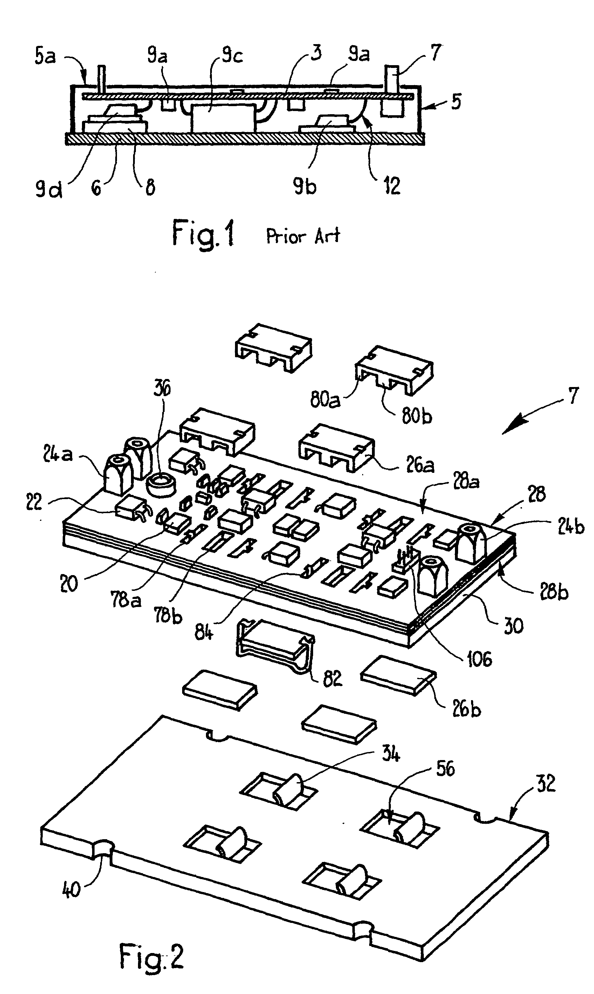

One approach to packaging electric components in power converters (Fig. 1) includes a housing which both encloses the components and means of heat extraction from the components. The house includes a non-conductive casing 5 and an aluminum heat-sinking base. A printed circuit board (PCB) 3 is mounted next to the upper wall 5a of the casing. Conductive pins 7 are attached directly to the PCB 3 and extend up through the wall 5a. Electronic components 9a, 9c are mounted to one or both sides of the PCB 3. Larger side components such as the transformer 9c are monted to the lower side for space reason. Power dissipating devices such as 9b are mounted directly on the base-plate 6 for better heat transfer. The power components 9b are electrically connected to the PBC by leads 12. Some of the power dissipating devices, 9d, are attached to the base plate via a thermally conductive insulator material 8. Structure 1 may be filled with an encapsulant, which acts as a heat spreader and provides mechanical support. In the case when a hard' epoxy encapsulant is used a"buffer coating" material is used to protect some of the components.

One of the biggest problems associated with electronic instruments is the disposal of waste energy that the components generate. often this is done through the use of a thermal sink which rests on a back portion of the electronic board. Heat from the electronic component is transferred from one side of the electronic board to the other through the use of a via.

Typically a via is a hole in the electronic board with often has its walls coated with copper. In production, the interior space of the via is filled with solder to provide for electrical connection and bonding. The vast majority of heat is transferred through the copper walls of the via.

While this technique works in general, it usually does not provide a very good cooling affect and often the electronic devices simply "cook" and become non-functional.

It is clear from the foregoing that there is a need for an improved cooling mechanism.

### Summary of the Invention:

This invention provides for an improved electronic board assembly in which thermal conductivity is greatly increased through the use of thermally conductive plug placed within the vias. Within a via, usually having its walls coated with copper, a thermally conductive plug (such as copper) is placed; this plug is then secured to the via and the electronic board by flowing and solidifying solder around the plug. Due to the heightened thermal characteristics of the plug, heat is more efficiently wicked away from the electronic elements to a heat sink or heat dissipation mechanism.

The thermal plug used within the via has thermal conductivity properties greatly improved over solder. Ideally, the thermal conductivity of the plug is at least 25 percent greater than solder. Thermal conductivity is the heat flow across a surface per unit time, divided by the negative of the rate of change of temperature with distance in a direction perpendicular to the surface. Those of ordinary skill in the art readily recognize a variety of such materials, including, but not limited to: substantially pure copper, substantially pure silver, and substantially pure aluminum.

For a PCB assembly, the electronic components are fastened to the top of the PCB. Typically, a large heat sink is positioned beneath the PCB. Under the electronic components are positioned one or more multiple vias which have their walls plated with copper. The vias of this invention are large enough to accept a large metal insert which forms a thermal slug. The thermal slub/metal insert is soldered to the PCB.

These metal inserts are much better thermal conductors than solder alone and provide for heightened conductivity so that heat from the electronic component is wicked to the heat sink or other mechanism used to discharge waste heat.

In the preferred embodiment, located directly underneath the PCB is an insulated multilayer substrate which aids in the transfer of heat form the PCB to the aluminum baseplate. This substrate is comprised of three different materials. The top layer is a thin copper foil. A portion of this copper foil is soldered to the under side of the PCB in the Location where the metal inserts protrude through the PCB. Electrical isolation from the rest of the foil is provided by cutting a small island in the this location which is to be soldered to the metal inserts. The rest of the copper foil is not soldered to the bottom of the PCB, it relies on pressure to provide the coupling for heat transfer. The middle layer of the substrate is a thermally conducting material which electrically insulates the copper foil layer from the bottom aluminum plate.

The PCB along with the substrate; in the preferred embodiment, is mounted to an aluminum baseplate. Any conductive devices, such as ferrite cores, are ideally electrically isolated from the baseplate by means of a compressible thermoconductive material.

In another aspect of this invention, a packaging technology is described for power converters and power magnetics. The packaging methodology provides a compact, inexpensive, easy to manufacture. The invention features a package for electrical components held on a circuit board. In this packaging concept most of the power magnetic elements are constructed into the multilayers PCB. The windings of the magnetic elements such as transformer, inductors, and in some cases event signal transformers are incorporated in the multilayers PCB. The top layer and some portion of the bottom layer are also support for electronic components. The windings of the magnetic elements are contained inside of the multilayers PCB; the electronic components are placed on the top and on the bottom of the PCB. Some of the components are located on top of the windings and the interconnections between the magnetic elements. In this way the footprint of the magnetic elements is reduced to the footprint of the transformer core. The power-dissipating devices replaced on pads, which have a multitude of copper coated via to the other side of the PCB. The heat transferred to the other side of the PCB can be further spread using a larger pad or transferred to a metallic base-plate attached to the PCS through an isolating material. For air-cooled due to the limited surface of the heat spreader, an additional heat sink is attache to the heat spreader to increase its cooling area.

The unique aspect of this packaging concept is the fact that the magnetic element's windings are incorporated on the multilayers PCB construction which also serves as a support for power-dissipating components and some of the control components. The heat from the power-dissipating components is extracted through copper coated via which transfer the heat to the other side of the PCB. The heat is further transferred to a metal base plate connected to the PCB via a thermally conductive insulator. For airflow cooling applications the heat.spreader connected to the thermal via can serve as a cooling surface. A heatsink can be also attached to the heat spreader to increased the heat dissipation area.

The invention, together with various embodiments thereof, will be more fully explained by the accompanying drawings and the following description.

### Drawings in Brief:

Figure 1 is a cross-sectional side view of prior art components packaging.
Figure 2 is a perspective exploded view of component packaging according to the invention.

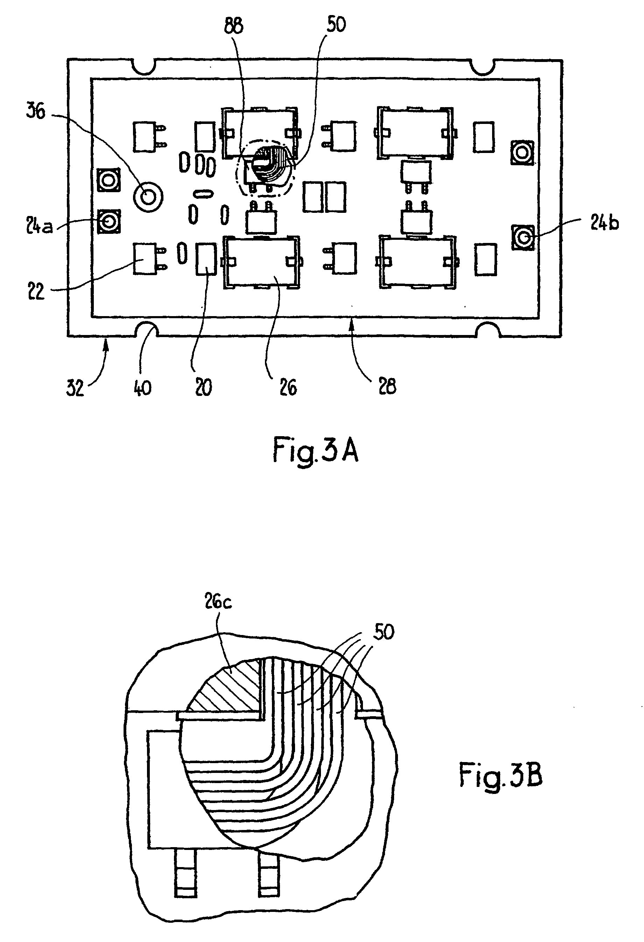

Figure 3A is a top view of the packaging with a detailed section of the magnetic' winding.
Figure 3B is an enlarged view of a section of Fig 3A

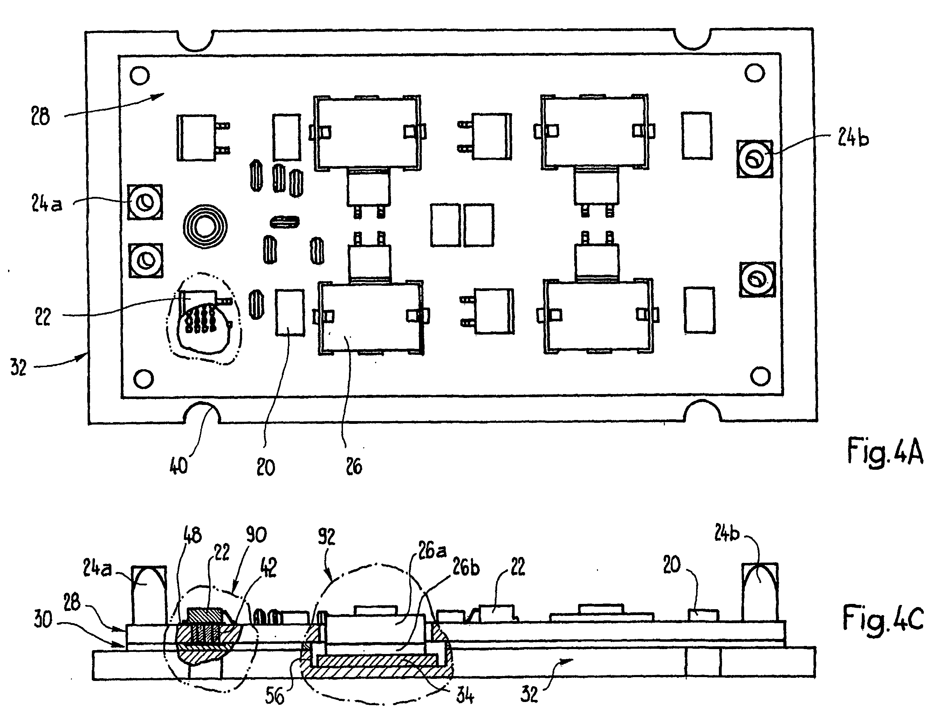

Figure 4A is a top view of the packaging with a detailed section of the cooling via.
Figure 4C is a section of the packaging through the cooling via and through a magnetic element.

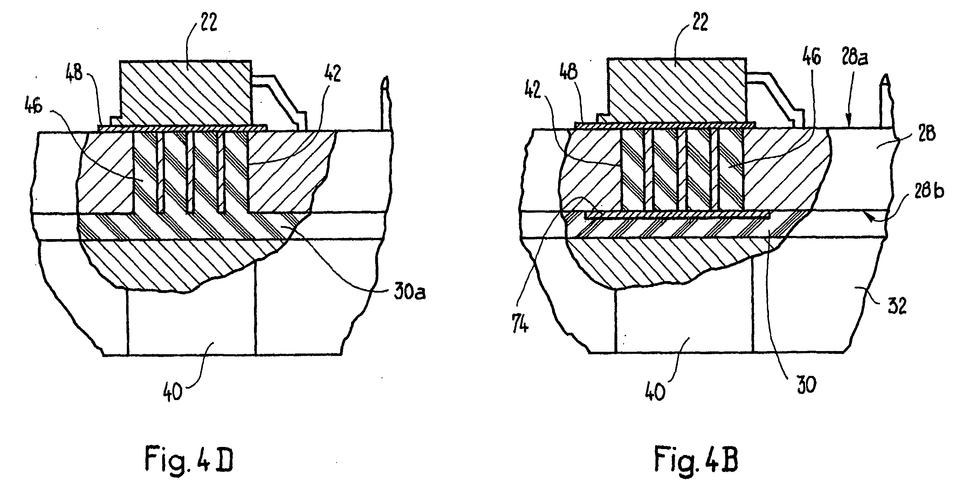

Figure 4D is a broken view of the cooling via herein the insulator material penetrates in the cooling via.
Figure 5A is the top view of the horizontal packaging with airflow cooling.

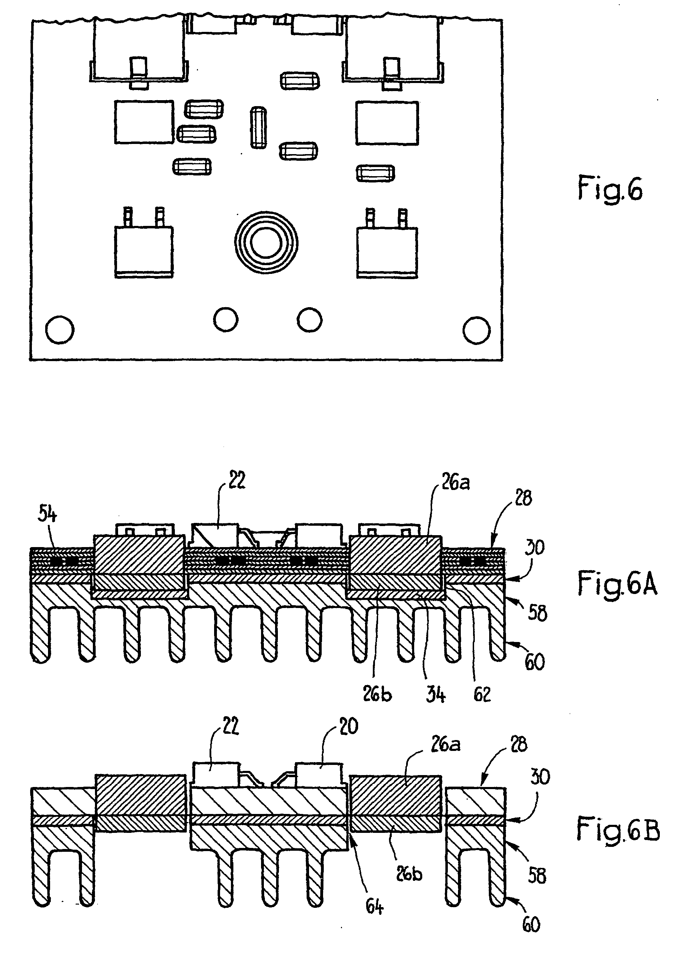

Figure 6 is a top view of the packaging
Figure 6A is a cross-section of the package with cooling by airflow and cavities for magnetic cores.
Figure 6B is a cross-section of the package with cooling by airflow and holes for magnetic cores.
Figure 7A it is a perspective view of the power packages for airflow cooling.
Figure 7B is a perspective view of the power packages for airflow cooling and additional heating applied to the multilayers circuit board.
Figure 8 is a cross-section of the packaging connected to the motherboard.
Figure 9 it is another embodiment of the present invention.
Figure 10A is a high power magnetics package according to this invention.
Figure 10B is a cross-section of the magnetic package presented in figure 10.

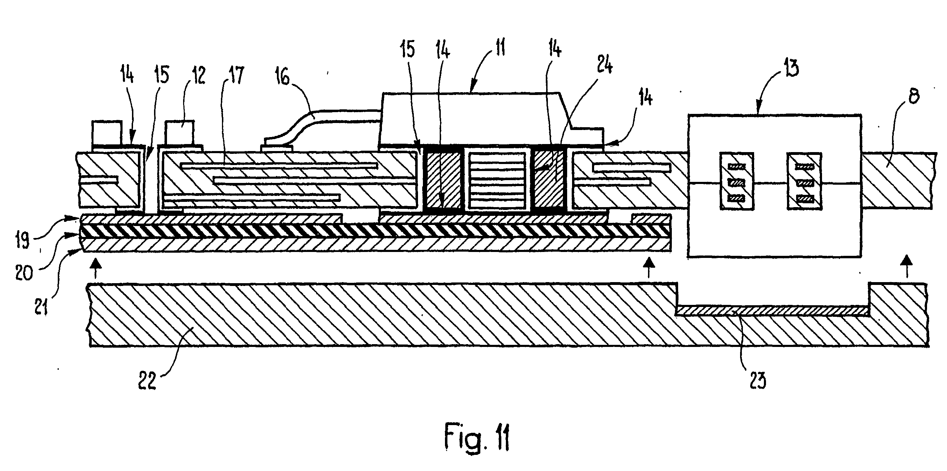

Figure 11 shows a cross-sectional diagram of the completed PCB assembly using the improved thermal coupling apparatus for this invention.

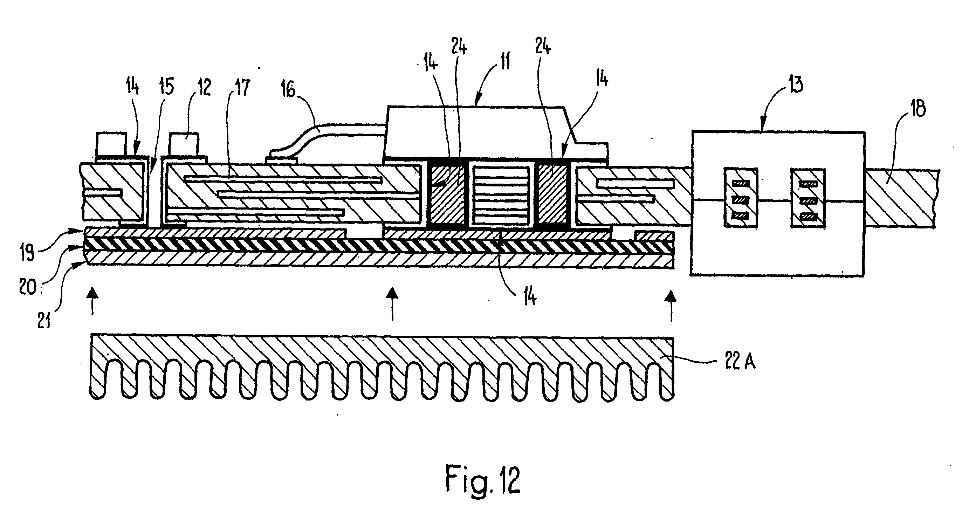

Figure 12 illustrates an embodiment of the invention which utilizes an additional heatsink.

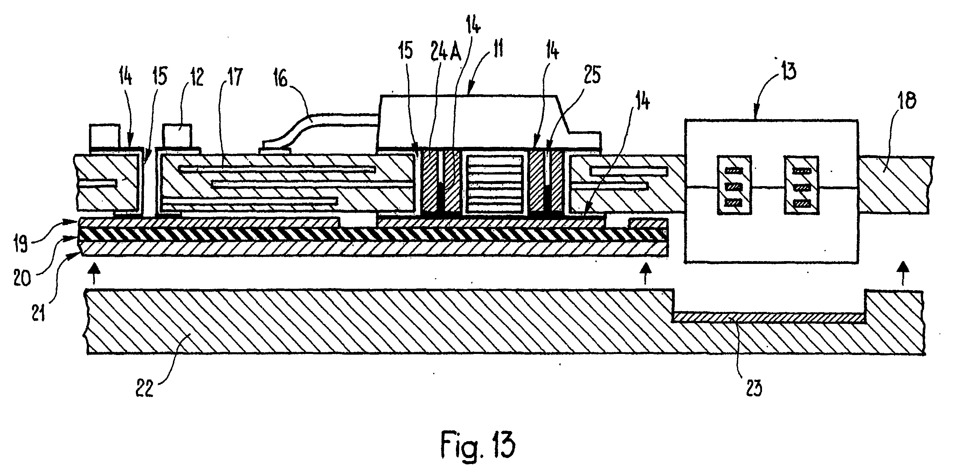

Figure 13 is still another embodiment of the invention in which the thermal slugs/inserts are wedged into the via.

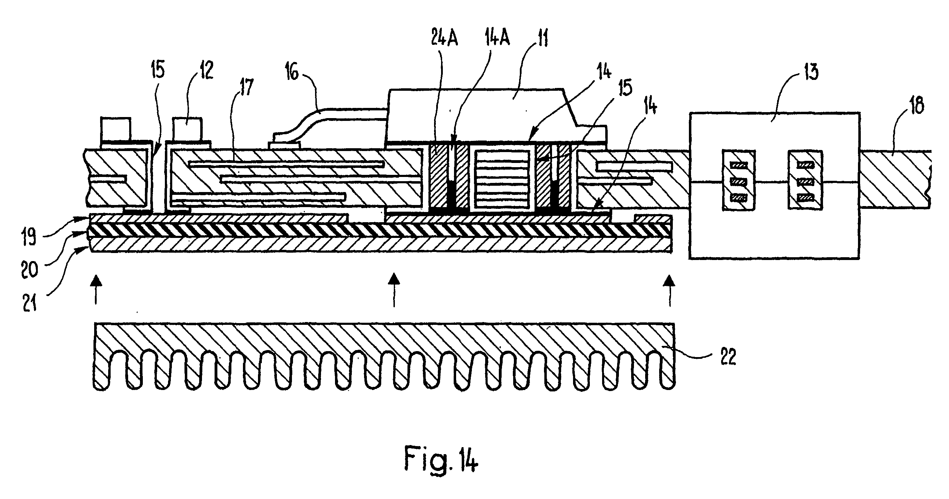

Figure 14 is still another embodiment of the thermal conductive aspect of this invention.

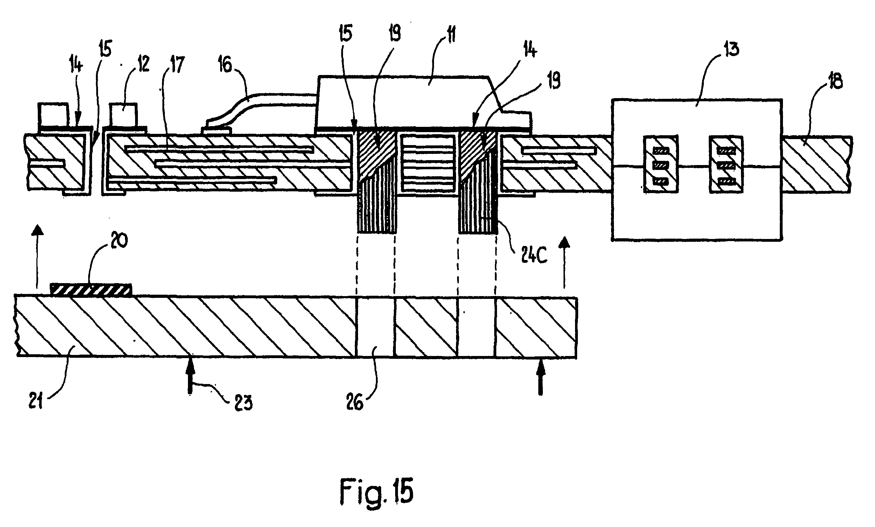

Figure 15 illustrates an alternative embodiment in which the metal slugs extend past the PCB and are used to secure the heatsink to the PCB.

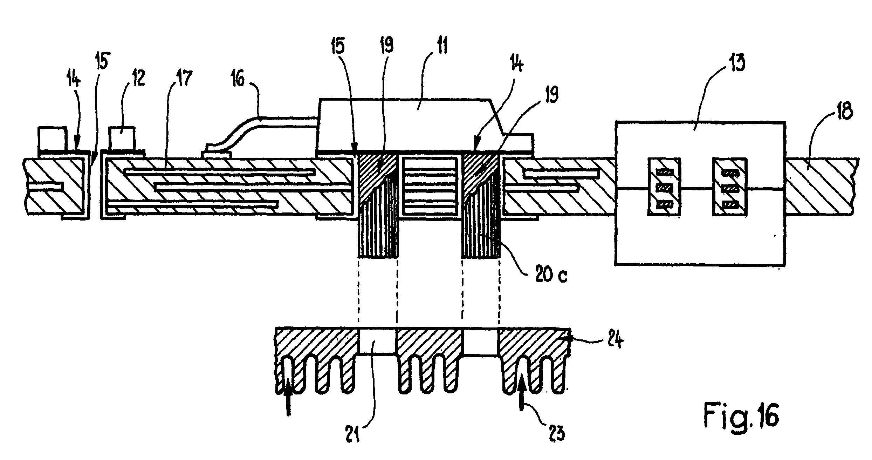

Figure 16 illustrates an embodiment of the invention having enhanced cooling capabilities.

### Drawings in Detail:

As noted and discussed earlier, figure 1, shows a prior art embodiment of the invention.

Referring to Fig 2 in the packaging 7 provided by this invention, a power-dissipating electronic components 22 are located on the multilayer PCB 28 on top of the heat spreader pad 48, Fig 4B. The heat spreader pad is connected to the copper coated via. A heat spreader 74, Fig 4B, is connected on the backside of the PCB through the copper coated via 42. The copper coated via can be filled with solder or can be empty in which case the heat will be transferred through the metalization placed on the wall of the via. The metalization is formed by copper deposit during the plating process associated with the manufacturing process of the PCB. As a result of the plating process the wall of the via is covered with copper. The via can be also filled with a thermally conductive material 30a as is presented in figure 4D. The isolated material 30 placed under the PCB 28 under pressure will penetrate through the via filling the space. In between the 28 and the metal base plate 32 an insulator material with good thermal conductivity characteristics 30 is placed. In this way the heat from the power dissipating components 22, is transferred through the copper pad 48 on which the power dissipating device is mounted, to the copper coated via 42 to the other side of the PCB, 28B, to the heat spreader 74. The heat is further transferred through the thermally conductive insulator material 30 to the metal plate 32. In the case wherein the insulator material 30 will penetrate through the copper coated via 42 the surface contact will increase and as a result the thermal transfer from the copper pad 48 to the metal plate 30 will be improved.

The main embodiments of this invention is the magnetic elements implementation in the multilayers PCB and the means in which the heat is extracted form the power dissipating devices, from the magnetic winding 50, (Figure 3A and Fig 3B), from the magnetic core 26A and 26B, and the low power dissipation devices 20 to the baseplate 32. To increase the power density, some components 88 are mounted on top of the multilayers PCB 28a, on top of the windings 50 embedded in the inner layers of the multilayers PCB 28. In this way the footprint of the magnetic element is reduced to the footprint of the magnetic core 26a.

The main embodiment of this invention is the fact that the magnetics elements are implemented in the multilayers PCB 28. In the prior art the magnetic elements were discrete devices which were connected to the PCB by means of through hole or surface mounted pins. The presence of the connecting pins increases the coast of the magnetic element and it reduces the reliability of the magnetic device due to the mechanical failure of the pins. The interconnection pin can be bent or broken easily. The presence of the interconnection pins adds supplementary stray inductance in series with the transformer. This will negatively impact the electrical performance of the circuit. In most of the applications the energy contained in this parasitic inductance is dissipated, reducing the parasitic inductance of the inter connection pins can increase to voltage or current stress on the electrical components.

In this invention the magnetic elements have the windings embedded inside of the multilayers PCB. The interconnection between the magnetic elements and between the magnetic elements and the electronic components are made through copper pads etched in the layers of the multilayers PCB and through the copper coated via 42 in the multiyear PCB 28. This allows the use of more complex winding arrangements and allows the use of more magnetic elements on the same multilayers PCB construction. The interconnections of these magnetic elements are made within the multilayer PCB. The converter will contain a number of smaller magnetic elements achieving a low profile package. The magnetic cores 26A and 26b will penetrate through multilayers PCB via the cutouts 78a and 78b fitted for the outer legs 80a and inner legs 80b. The magnetic sections 26a and 26b can be glued together or attached via a spring clips 82. To accommodate the spring clip additional cutouts in the PCB 84 are produced. The bottom side of the magnetic core 26b, will surface on the back of the PCB. To be able to accommodate the magnetic cores 26b cutouts 86 are made through the insulator material 30. In most of applications the thickness of the insulator material is smaller than the height of the magnetic core. To accommodate the magnetic core 26b, cavities 56, are produced into the base plate 32. Due to the fragile characteristic of the magnetic cores, a soft pad 56, with small thermal impedance is placed under the magnetic core 26b in the cavity. The pad 56, will dampen the vibration of the magnetic core, The low thermal impedance of the pad 56, will also offer a cooling path for the magnetic core. In some applications wherein insulation has to be achieved to the base plate, the pad, 56 have to have insulation properties.

The entire structure 7 is press together in a way that the magnetic core 26b will be placed on top of the pad 56. The thickness of the pad has to chosen in a way that the metallic plate 32 makes good contact with the insulator 30. The insulator 30, is pressed between the PCB 28 and metal plate 32. The permanent attachment can be done in several ways. In the preferred embodiment the isolator material 30 has adhesive properties stimulated by a curing process at higher temperature. After the curing process the insulator created a bound between the PCB 28, and the metal plate 32. In applications wherein the structure 28 is connected to anther plate, the flanges 40 can accommodate screws.

A cross-section of the structure 7, mounted is presented in Fig. 4C. A section of the structure is blown in figure 4B. In the cross-section of the structure 90 is presented the location of a power dissipation device on top of the copper pad 48, and the coated via 42. The copper coated via carry the heat to the heat spreader 74. The heat is further transferred via the thermally conductive insulator 30 to the metal plate 32.

A second cross-section of the mounted structure 7, is presented in figure 4C. In the cross-section, 92, is presented the upper section of the magnetic core 26a, the bottom section of the magnetic core 26b, the pad under the magnetic core 34 located in the cavity 56. The heat generated in the magnetic core 26 is transferred to the base plate through the pad 34. For components which have to have a temperature close to the temperature of the base plate, copper coated via are placed under the components or to the traces and pad connected to the components. In this way low thermal impedance is achieved to the base plate. With low thermal impedance to the base plate, the temperature rise of these components will be small.

Using screws, clips, or different means of applying pressure to the structure 7 can also make the attachment of the PCB 28, to the isolator 30 and the base-plate 32. In some applications the cutouts in the metallic plate 32 can penetrate through the plate. The magnetic cores 26b will be visible from the bottom side of the metallic plate. For protecting the magnetic cores 26b, soft epoxy material can cover the remaining cavity in between the magnetic core and the surface of the base plate 32. In some application that cavity can be left open.

In figure 8 is presented a structure 9 wherein the package 7 is attached to a motherboard 96. The attachment is done through the power connectors 24a and 24b. The power connectors are attached to the motherboard 96 through screws 98. There is a signal connector 106 located on the structure 7. The signal connector 106 is connected to the matching signal connector 104 located on motherboard 96. More than one structure 7 can be connected to the same motherboard 96. On the motherboard 96 there are additional components 100 and 102. This structure it is suitable for systems wherein only the power train and some control functions are located on the structure 7. Some of the control section components, supplementary logic circuits and EMI filters are located on the motherboard. The bottom layer of the motherboard 96 may contain copper shields to protect the ncise sensitive components. The noise sensitive components are located on the motherboard and the power dissipate components, some control components and the magnetics are located on the structure 7.

In figure 5a and 5b is presented a packaging structure 11. In this structure the magnetic element has its winding embedded within the multilayers PCB 28 as it is in structure 7. The components are located on both sides of the multilayers PCB. This packaging structure applies to low power dissipation application wherein there is an airflow. The entire surface of multilayers PCB 28 becomes a heatsink. The structure 11 is connected to the other circuitry via the pins 52.

In figure 7A is depicted a power system which contains several packaging structures 15. 'The structure 15 include the magnetic elements 26, the power dissipating components 22, the low power dissipation components 20, similar with structure 7. The main difference is that there is not an isolator 30, and a base plate 32. The cooling is accomplished by the air, which flows in between the packaging structures 15. The entire surface of 15 becomes a heatsink. The structures 15 are connected to the motherboard 64 through signal connectors 70a, and power connectors 70b.

Supplementary components are located on the motherboard 64.

In figure 7B the motherboard 64 is connected to two packaging structures 17. These packaging structures contain the same components as structure 15 with an additional heat sink 58 attached to the multilayers PCB 28 through the insulator 30.

Two types of heatsink construction are presented in figure 6A and ^B. In figure 6A the heatsink 58 has air fins 60 and cavities 62. In the cavities a soft compressible material 34, with low thermal impedance is placed. The insulator with low thermal impedance 30 is placed between the multilayers PCB 28 and the base plate 58. The magnetic core 26b is cooled via the soft pad 34. The power-dissipation devices are cooled though copper coated via like in structure 7.

In figure 6B the heatsink 58 with air fins 60 has cutout-outs 64 to accommodate for the magnetic core 26b. The cooling of the magnetic core 26a and 26b is accomplished by the airflow. The cooling of the power-dissipation devices is done through copper coated via 42.

In figure 9 is presented a packaging structure wherein the metal plate 32 does not contain cavities. It has elevated sections 104, which makes contact with the thermally conductive insulator 30, which is placed under the multilayers PCB 28. The elevated sections of the metal plate 104 are primarily placed under the power dissipated devices 22 and other low dissipation components 20c which require to have a temperature close to the base plate temperature. The thermally conductive soft pad 34, on the base plate 32 supports the magnetic core 26a and 26b. The height of the elevated section of the baseplate 104, are function of the height of the magnetic core 26b and the compression ratio of the pad 34. The advantage of the packaging concept is the fact that more components can be mounted on the multilayers PCB on the backside 20b. This package is suitable for power converters, which contains all the control and signal interface functions. The interconnection pins 24a and 24b will provide the power and signal connections to the outside word. The cover 106 contains holes 110 to accommodate the interconnection pins 24a and 24b.

For the purpose of attaching case 106 to the baseplate 32 (figure 9) teeth 112 are formed along the lower edge of the case. A matching grove 108 is undercut into the base plate 32.

In figure 10A is presented a high power magnetic structure wherein the magnetic core is formed by several small magnetic cores 26. A cross-section through the structure 19 is presented in figure 10B. The windings 50 of the magnetic structure are embedded in the multilayer PCB layers. The cutout 116 in the multilayers PBC 28 are made to accommodate the magnetic cores 26. Power connectors are inserted in the multilayers PBC 28. The connectors 24a and 24b are connected to the windings 50. The cores 26a and 26b are attached together via the clips 82. The multilayers PCB 28 wherein the windings 50 are embedded into also offers supports for the magnetic cores 26. A cavity 56 is placed in the base plate 32. A thermally conductive soft pad is placed under the magnetic core 26b on top of base plate 32.

Figure 11 shows a cross-sectional diagram of the completed PCB assembly using the improved thermal coupling apparatus for this invention.

The basic components for this embodiment are: power device 11, other devices 12, magnetic cores 13, solder 14, via with plated copper walls 15, legs of the power device 16, inner layers 17, printed circuit board (PCB) having multilayers 18, copper foil 19, insulation material 20, metal plate 21, addtional heat sink 22, compressible thermoconductive material 23, and metal insert 24.

Electrical components (11, 12 and 13) are assembled on a multilayer PCB (18). Under the power device (11) are one or more multiple vias (15) which are plated with copper. Vias 15 are large enough to accept a large metal insert (24) which is soldered to the PCB. These metal inserts are much better thermal conductors than solder alone.

In this context, the thermal insert/ plug 24 used within the via has thermal conductivity properties improved over solder. Ideally, the thermal conductivity of the plug is at least 25 percent greater than solder. Thermal conductivity is the heat flow across a surface per unit time, divided by the negative of the rate of change of temperature with distance in a direction perpendicular to the surface. Those of ordinary skill in the art readily recognize a variety of such materials, including, but not lim ited to: substantially pure copper, substantially pure silver, and substantially pure alumina.

Located directly underneath the PCB is an insulated multilayer substrate which aids in the transfer of heat form the PCB to the aluminum baseplate. This substrate is comprised of three different materials. The top layer is a thin copper foil (19). A portion of this copper foil (19) is soldered to the under side of the PCB in the location where the metal inserts (24) protrude through the PCB. Electrical isolation from the rest of the foil is provided by cutting a small island in the this location which is to be soldered to the metal inserts (24). The rest of the copper foil (19) is not soldered to the bottom of the PCB, it relies on pressure to provide the coupling for heat transfer. The middle layer of the substrate (20) is a thermally conducting material which eleetrically insulates the copper foil layer from the bottom aluminum plate (21).

The PCB along with the substrate may then be mounted to an aluminum baseplate (22). Any conductive devices such as ferrite cores (23) may be electrically isolated from the baseplate by means of a compressible thermoconductive material.

The method of operation for this system is to solder the power device to the top of the PCB, on top of the soldered metal inserts. The heat generated during electrical operation of the circuit is easily transmitted through the metal inserts. The heat is spread out over a large surface area through the insulation material to the aluminum plate and to the baseplate.

The power device 11 is optionally a die placed on the metal insert 24 and with bond wire connected to the multilayer PCB.

Figure 12 illustrates an embodiment of the invention which utilizes an additional heatsink.

As before, electrical components (11, 12 and 13) are assembled on a multilayer PCB (18). Under the power device (11) there are multiple vias (15) which are plated with copper.

These improved vias 15 are larger than traditional vias to accept the metal insert/slug 24. Solder provided during the manufacture ofthe PCB (18) flows around the insert/slug 24 to bond the assembly together.

Located directly underneath the PCB is an insulated multilayer substrate which aids in the transfer of heat from the PCB to the aluminum heatsink. This substrate is comprised of three different materials. The top layer is a thin copper foil (19). A portion of this copper foil (19) is soldered to the under side of the PCB (18) in the location where the metal insert protrude through the PCB (18).

Electrical isolation from the rest of the foil is provided by cutting a small island in this location which is to be soldered to the metal inserts/slugs 24. The rest of the copper foil (19) is not soldered to the bottom of the PCB, it relies on pressure to provide the coupling for heat transfer. The middle layer of the substrate (20) is a thermally conducting material which electrically insulates the copper foil layer from the bottom aluminum plate conducting material which electrically insulates the copper foil layer from the bottom aluminum plate (21). The PCB along with the substrate is then be mounted to an aluminum heatsink (22A).

The method of operation for this system is to solder the power device to the top of the PCB above the soldered metal inserts. The heat generated during electrical operation of the circuit is transmitted through the metal inserts to the copper foil island underneath. This island is large compared to the metal inserts to allow for greater thermal conductivity. The heat is spread out over a large surface area through the insulation material to the aluminum plate and to the heatsink.

The size of the copper foil layer 19 underneath the metal insert is tailored to control the capacitance between the power device 11 and heat sink 22.

Figure 13 is still another embodiment of the invention in which the thermal slugs/inserts are wedged into the via.

In this embodiment, the metal inserts/slugs 24A are also unique in that they have a small through hole which extends from its top to bottom. This allows for a good solder flow due to a capillary action when the insert is soldered from a portion of the underlying multilayer substrate to the power device on top side of the PCB. The metal inserts/slugs 24A have a diameter greater than the diameter of the via with its walls coated with copper.

This requires the metal insert/slug 24A to be "wedged" into the via. The solder flows through the internal channel to connect the top of PCB 18 to the bottom.

The PCB along with the substrate is mounted to an aluminum baseplate (22). Any conductive devices such as ferrite cores (13) may be electronically isolated from the baseplate by means of compressible thermoconductive material.

The method of operation for this system is to solder the power device to the top of the PCB, on top of the pressure fitted metal inserts. The heat generated during electrical operation of the circuit is transmitted through the metal inserts so there is no decrease in the thermal resistivity of this junction. The heat is spread out over a large surface area through the insulation material to the aluminum plate and to the baseplate.

Figure 14 is still another embodiment of the thermal conductive aspect of this invention.

As with the prior embodiments, the embodiment of figure 14 includes the electrical components (11, 12 and 13) are assembled on a multilayer PCB (18). In this embodiment, the metal inserts (24A) have a small through hole 14A which extends from its top to bottom. This allows for a good solder flow due to a capillary action when the insert is soldered from a portion of the underlying multilayer substrate to the power device on the top side of the PCB (18).

The substrate is located directly underneath the PCB and its function is to aid in the transfer of heat from the PCB to the aluminum heatsink. This substrate is comprised of three different materials. The top layer is a thin copper foil (19). The PCB along with the substrate is mounted to an aluminum heatsink (22).

The method of manufacture for this system is to solder the power device to the top of the PBC, on top of the pressure fitted metal inserts (24A). The heat generated during electrical operation of the circuit is transmitted through the metal inserts (24A). The heat generated during electrical operation of the circuit is transmitted through the metal inserts to the copper foil island underneath. This island is large compared to the metal inserts so there is no decrease in the thermal resistivity of this junction. The heat is spread out over a large surface area through the insulation material to the aluminum plate and to the baseplate.

Figure 15 illustrates an alternative embodiment in which the metal slugs extend past the PCB and are used to secure the heatsink to the PCB.

In this embodiment, metal inserts/slug 24C have a length sufficient to extend through the PCB and also through holes 26 of heat sink 23.

The PCB assembly is mounted to an aluminum baseplate (23), acting as a heatsink, which has holes (26) to accompany the metal inserts (24C). A tight pressure fit is required for good thermal transfer. Any conductive devices such as ferrite cores (13) or smaller electrical vias (15) may be electrically isolated from the base plate by means of a compressible thermoconductive material.

Manufacture of this embodiment is to solder the power device to the top of the PCB, on top of the pressure fitted metal inserts. The heat generated during electrical operation of the circuit is transmitted through the metal inserts directly to the aluminum baseplate underneath.

Metal insert/slug 20C have a contoured exterior wall to allow liquid solder to flow therebetween to provide for bonding and also for electrical conductivity.

Figure 16 illustrates an embodiment of the invention having enhanced cooling capabilities.

In this embodiment, metal inserts/slugs (20C) are elongated to pass through PCB (18) and engage cooling vane 24. As with the illustration of figure 15, the embodiment of figure 16 uses metal inserts/slugs 20C which mechanically engage the walls of vias (14) and the holes 21 within the cooling vane 24. Metal insert/slug 20C have a contoured exterior wall to allow liquid solder to flow therebetween to provide for bonding and also for electrical conductivity.

It is clear from the foregoing that the present invention provides for greatly enhanced cooling capabilities ofan electronic board.

## Claims

1. A modular power supply, comprising:
a plurality of power supply modules (230), each power supply module having a power circuit (232) coupled to a power input of the module for receiving an input power current and for producing an output power current at a power output of the module, said power circuits each including at least one switching element (242) for switching the respective said input power current or the respective said output power current, said power circuits each further including a control circuit input (234) that is coupled directly to the respective said switching device; and
a system control circuit (240) for controlling said power supply modules, said system control circuit having a control circuit output bus (235) for connecting to the respective said control circuit inputs of each of said power modules and providing a respective control signal to each said module for directly controlling the respective said switching devices in such manner that said modules may be controlled independently of each other.

2. The modular power supply of claim 1, wherein said power circuits each include at least one sensing element (280) for sensing a condition of the respective said input power current or the respective said output power current, said power circuits each further including a control circuit output (236) that is coupled directly to the respective said sensing elements for providing a respective sense signal to said system control circuit, and wherein said system control circuit further includes a control circuit input bus (237) for connecting to the respective said control circuit outputs of each of said power modules and directly receiving said respective sense signals from said modules.

3. The modular power supply of claim 1, wherein
said power input of each power module is relatively unfiltered;
said output power current of each power module is relatively unfiltered;
said system control circuit comprises an input filter and an output filter;
said relatively unfiltered power inputs of said modules receiving the respective
said input power currents from said input filter and said output filter receiving the respective said relatively unfiltered output power currents from said modules.

4. A method for forming a power supply, comprising:
providing a plurality of power supply modules (230), each power supply module having a power circuit (232) coupled to a power input of the module for receiving an input power current and for producing an output power current at a power output of the module, said power circuits each including at least one switching device (242) for switching the respective said input power current or the respective said output power current, said power circuits each further including a control circuit input directly coupled to the respective said switching device;
providing a system control circuit (240) having a control circuit output bus (235) for connecting to the respective said control circuit inputs of each of said power modules; and
directly controlling the respective said switching devices by providing respective control signals for controlling each of said modules on said control circuit output bus independently of one another.

5. The method of claim 4, further comprising providing each said power circuits with at least one sensing element (280) for sensing a condition of the respective said input power current or the respective said output power current, providing each said power circuits with a control circuit output (236) that is coupled directly to the respective said sensing elements for providing a respective sense signal to said system control circuit, providing said system control circuit with a control circuit input bus (237) for connecting to the respective said control circuit outputs of each of said power modules, and directly receiving said respective sense signals from said modules.

6. The method of claim 4, further comprising providing a system input filter having a power input and a power output coupled to each of the power inputs of said modules, sequencing said power modules to increase the ripple frequency of the current through said power input of said system input filter, and providing the size of said system input filter to be smaller than would be required without said step of sequencing.

7. The method of claim 4, wherein said step of providing said system control circuit includes providing programmable control thereof, the method further comprising the steps of programming said system control circuit to provide'a program of output currents from said modules, and subsequently reprogramming said system control circuit to provide a different program of output currents from said modules.

8. The method of claim 4, further comprising providing an input filter for receiving at an input thereof a system input power current, an output fitter for producing at an output thereof a system output power current, and coupling said power inputs of said modules to an output of said input filter, and coupling said power outputs of said modules to an input of said output filter.

## Patentansprüche

1. Modulare Stromversorgung mit
einer Vielzahl von Stromversorgungsmodulen (230), wobei jedes Stromversorgungsmodul einen Stromkreis (232) aufweist, der mit einem Stromeingang des Moduls gekoppelt ist, um einen Eingangsstrom zu erhalten und einen Ausgangsstrom an einem Stromausgang des Moduls zu erzeugen, wobei jeder Stromkreis mindestens ein Schaltelement (242) zum Schalten des jeweiligen Eingangsstroms oder des jeweiligen Ausgangsstroms sowie darüber hinaus einen Regelkreiseingang (234) aufweist, der unmittelbar mit dem jeweiligen Schaltelement gekoppelt ist; und
einem System regelkreis (240) zum Regeln der Stromversorgungsmodule mit einem Regelkreisausgangsbus (235) zum Anschluss an die jeweiligen Regelkreiseingänge jedes Strommoduls und zum Bereitstellen eines jeweiligen Regelungssignals für jedes der Module zur unmittelbaren Regelung des jeweiligen Schaltelements derart, dass die Module unabhängig voneinander geregelt werden können.

2. Modulare Stromversorgung nach Anspruch 1, **dadurch gekennzeichnet, dass** jeder Stromkreis mindestens einen Messfühler (280) zum Messen eines Zustands des jeweiligen Eingangsstroms oder des jeweiligen Ausgangsstroms aufweist, dass jeder Stromkreis darüber hinaus einen Regelkreisausgang (236) aufweist, der unmittelbar mit dem jeweiligen Messfühler verbunden ist, um dem System regelkreis ein entsprechendes Messsignal bereitzustellen, und dass der Systemregelkreis des weiteren einen Regelkreiseingangsbus (237) zum Anschluss an den jeweiligen Regelkreisausgang jedes der Strommodule und zum direkten Erhalten der jeweiligen Messsignale der Module aufweist.

3. Modulare Stromversorgung nach Anspruch 1, **dadurch gekennzeichnet, dass**
der Stromeingang jedes Strommoduls relativ ungefiltert ist;
der Ausgangsstrom jedes Strommoduls relativ ungefiltert ist;
der Systemregelkreis einen Eingangsfilter und einen Ausgangsfilter aufweist;
die relativ ungefilterten Stromeingänge der Module die jeweiligen Eingangsströme vom Eingangsfilter erhalten und der Ausgangsfilter die jeweiligen relativ ungefilterten Ausgangsströme von den Modulen erhält.

4. Verfahren zum Bilden einer Stromversorgung mit den folgenden Schritten:
Bereitstellen einer Vielzahl von Stromversorgungsmodulen (230), wobei jedes Stromversorgungsmodul einen Stromkreis (232) aufweist, der mit einem Stromeingang des Moduls gekoppelt ist, um einen Eingangsstrom zu erhalten und einen Ausgangsstrom an einem Stromausgang des Moduls zu erzeugen, wobei jeder Stromkreis mindestens ein Schaltelement (242) zum Schalten des jeweiligen Eingangsstroms oder des jeweiligen Ausgangsstroms sowie darüber hinaus einen Regelkreiseingang (234) aufweist, der unmittelbar mit dem jeweiligen Schaltelement gekoppelt ist;
Bereitstellen eines Systemregelkreises (240) mit einem Regelkreisausgangsbus (235) zum Anschluss an die jeweiligen Regelkreiseingänge jedes Strommoduls; und
direktes Regeln der jeweiligen Schaltelemente durch das Bereitstellen von jeweiligen Regelsignalen am Regelkreisausgangsbus zum voneinander unabhängigen Regeln der Module.

5. Verfahren nach Anspruch 4, **gekennzeichnet durch** ein Ausrüsten jedes Strommoduls mit mindestens einem Messfühler (280) zum Messen eines Zustands des jeweiligen Eingangsstroms oder des jeweiligen Ausgangsstroms, Ausrüsten jedes Stromkreises mit einem Regelkreisausgang (236), der unmittelbar mit den jeweiligen Messfühlern gekoppelt ist, um ein jeweiliges Messsignal für den Systemregelkreis bereitzustellen, Ausrüsten des Systemsregelkreises mit einem Regelkreiseingangsbus (237) zum Anschluss der jeweiligen Regelkreisausgänge jedes Strommoduls, und direktes Erhalten der jeweiligen Messsignale von den Modulen.

6. Verfahren nach Anspruch **4, gekennzeichnet durch** ein Bereitstellen eines Systemeingangsfilters mit einem Stromeingang und einem Stromausgang, der mit jedem der Stromeingänge der Module verbunden ist, Sequenzialisieren der Strommodule, um die Welligkeitsfrequenz des Stroms **durch** den Stromeingang des Systemeingangsfilters zu erhöhen, und Bereitstellen der Größe des Systemeingangsfilters derart, dass er kleiner ist, als er ohne den Schritt des Sequenzialisierens wäre.

7. Verfahren nach Anspruch 4, **dadurch gekennzeichnet, dass** der Schritt des Bereitstellens des Regelkreises das Bereitstellen einer dazu gehörenden programmierbaren Steuerung umfasst, und dass das Verfahren ferner die Schritte des Programmierens des Systemregelkreises, um ein Programm von Ausgangsströmen von den Modulen bereitzustellen, sowie eines nachfolgenden Reprogrammierens des Systemregelkreises, um verschiedene Programme von Ausgangsströmen von den Modulen zur Verfügung zu stellen, umfasst.

8. Verfahren nach Anspruch 4, **gekennzeichnet durch** Bereitstellen eines Eingangsfilter zum Erhalten eines Systemeingangsstroms an seinem Eingang, eines Ausgangsfilters zum Erzeugen eines Systemausgangsstroms an seinem Ausgang, und Verbinden der Stromeingänge der Module mit einem Ausgang des Eingangsfilters sowie Verbinden der Stromausgänge der Module mit einem Eingang des Ausgangsfilters.

## Revendications

1. Bloc d'alimentation de puissance modulaire, comprenant :
une pluralité de modules d'alimentation de puissance (230), chaque module d'alimentation de puissance comportant un circuit de puissance (232) couplé à une entrée de puissance du module pour recevoir un courant de puissance d'entrée et pour produire un courant de puissance de sortie à une sortie de puissance du module, lesdits circuits de puissance comprenant chacun au moins un élément de commutation (242) pour commuter ledit courant de puissance d'entrée respectif ou ledit courant de puissance de sortie respectif, lesdits circuits de puissance comprenant chacun, de plus, une entrée de circuit de commande (234) qui est couplée directement au dispositif de commutation respectif ; et
un circuit de commande de système (240) pour commander lesdits modules d'alimentation de puissance, ledit circuit de commande de système comportant un bus de sortie de circuit de commande (235) pour connecter aux entrées de circuit de commande respectives de chacun desdits modules de puissance et fournir un signal de commande respectif à chaque dit module pour commander directement lesdits dispositifs de commutation respectifs, de telle sorte que lesdits modules puissent être commandés indépendamment l'un de l'autre.

2. Bloc d'alimentation de puissance modulaire selon la revendication 1, dans lequel lesdits circuits de puissance comprennent chacun au moins un élément de détection (280) pour détecter une condition du courant de puissance d'entrée respectif ou du courant de puissance de sortie respectif, lesdits circuits de puissance comprenant chacun, de plus, une sortie de circuit de commande (236) qui est couplée directement aux éléments de détection respectifs pour fournir un signal de détection respectif audit circuit de commande de système, et dans lequel ledit circuit de commande de système comprend, de plus, un bus d'entrée de circuit de commande (237) pour connecter auxdites sorties respectives du circuit de commande de chacun desdits modules de puissance et recevoir directement lesdits signaux de détection respectifs en provenance desdits modules.

3. Bloc d'alimentation de puissance modulaire selon la revendication 1, dans lequel
ladite entrée de puissance de chaque module de puissance est relativement non filtrée ;
ledit courant de puissance de sortie de chaque module de puissance est relativement non filtré ;
ledit circuit de commande de système comprend un filtre d'entrée et un filtre de sortie ;
lesdites entrées de puissance relativement non filtrées desdits modules recevant les courants de puissance d'entrée respectifs en provenance dudit filtre d'entrée et ledit filtre de sortie recevant les courants de puissance de sortie relativement non filtrés respectifs en provenance desdits modules.

4. Procédé pour former un bloc d'alimentation de puissance, comprenant :
la mise en place d'une pluralité de modules d'alimentation de puissance (230), chaque module d'alimentation de puissance comportant un circuit de puissance (232) couplé à une entrée de puissance du module pour recevoir un courant de puissance d'entrée et pour produire un courant de puissance de sortie à une sortie de puissance du module, lesdits circuits de puissance comprenant chacun au moins un dispositif de commutation (242) pour commuter le courant de puissance d'entrée respectif ou le courant de puissance de sortie respectif, lesdits circuits de puissance comprenant chacun, de plus, une entrée de circuit de commande directement couplée audit dispositif de commutation respectif ;
la mise en place d'un circuit de commande de système (240) comportant un bus de sortie de circuit de commande (235) pour la connexion auxdites entrées de circuit de commande de chacun desdits modules de puissance ; et
la commande directe des dispositifs de commutation respectifs en fournissant des signaux de commande respectifs pour commander chacun desdits modules sur ledit bus de sortie de circuit de commande indépendamment l'un de l'autre.

5. Procédé selon la revendication 4, comprenant de plus la mise en place de chacun desdits circuits de puissance avec au moins un élément de détection (280) pour détecter une condition dudit courant de puissance d'entrée respectif ou dudit courant de puissance de sortie respectif, fournissant à chacun desdits circuits de puissance une sortie de circuit de commande (236) qui est couplée directement auxdits éléments de détection respectifs pour fournir un signal de détection respectif audit circuit de commande de système, fournissant audit circuit de commande de système un bus d'entrée de circuit de commande (237) pour la connexion auxdites sorties de circuit de commande respectives de chacun desdits modules de puissance, et la réception directe desdits signaux de détection respectifs en provenance desdits modules.

6. Procédé selon la revendication 4, comprenant de plus la mise en place d'un filtre d'entrée de système comportant une entrée de puissance et une sortie de puissance couplées à chacune des entrées de puissance desdits modules, le séquençage desdits modules de puissance pour augmenter la fréquence d'ondulation du courant à travers ladite entrée de puissance dudit filtre d'entrée de système et le dimensionnement dudit filtre d'entrée de système, de façon à être plus petit que cela ne serait nécessaire sans ladite étape de séquençage.

7. Procédé selon la revendication 4, dans lequel ladite étape de mise en place dudit circuit de commande de système comprend la mise en oeuvre de sa commande programmable, le procédé comprenant, de plus, les étapes de programmation dudit circuit de commande de système pour fournir un programme de courants de sortie en provenance desdits modules, et la re-programmation consécutive dudit circuit de commande de système pour fournir un programme différent de courants de sortie en provenance desdits modules.

8. Procédé selon la revendication 4, comprenant de plus la mise en place d'un filtre d'entrée pour recevoir à son entrée un courant de puissance d'entrée de système, un filtre de sortie pour produire à un niveau de sortie un courant de puissance de sortie de système, et le couplage desdites entrées de puissance desdits modules à une sortie dudit filtre d'entrée, et le couplage desdites sorties de puissance desdits modules à une entrée dudit filtre de sortie.
